(19) Europäisches Patentamt
European Patent Office
Office européen des brevets

(11) **EP 1 675 180 B1**

(12) **EUROPEAN PATENT SPECIFICATION**

(45) Date of publication and mention
of the grant of the patent:
**09.12.2009 Bulletin 2009/50**

(51) Int Cl.:
*H01L 21/8247* *(2006.01)* *H01L 21/28* *(2006.01)*

(21) Application number: **04425936.4**

(22) Date of filing: **22.12.2004**

(54) **Methode of making a non-volatile MOS semiconductor memory device**

Herstellungsverfahren für Festwert-MOS-Halbleiterspeicherbauelement

Procédé de fabrication d' un dispositif semi-conducteur MOS de mémoire rémanente

(84) Designated Contracting States:
**DE FR GB IT**

(43) Date of publication of application:
**28.06.2006 Bulletin 2006/26**

(73) Proprietor: **STMicroelectronics S.r.l.**
**20041 Agrate Brianza (Milano) (IT)**

(72) Inventors:
• **Servalli, Giorgio**
**24040 Ciserano (BG) (IT)**
• **Brazzelli, Daniela**
**21052 Busto Arsizio (VA) (IT)**

(74) Representative: **Bartle, Robin Jonathan**
**W.P. Thompson & Co.**
**Coopers Building**
**Church Street**
**Liverpool**
**L1 3AB (GB)**

(56) References cited:
**EP-A- 1 091 392** **WO-A-00/51188**
**US-A- 6 153 472** **US-A1- 2002 160 570**
**US-A1- 2003 077 907**

**Description**

The present invention relates to a method of making a semiconductor memory device.

More precisely, the present invention relates to a method of making a floating gate non-volatile MOS memory device.

Memories are devices able to store and to make accessible information stored in binary form as bits, and they can be subdivided in various categories according to the storage capacity and to the time necessary to retrieve the information stored therein.

Semiconductor memories are made in MOS (metal-oxide-semiconductor) technology on a semiconductor material substrate, typically single crystalline silicon, and are called non-volatile when they retain the information for considerable times and in absence of power supply.

Among non-volatile MOS memories, a particularly important class is that constituted by floating gate devices, in which the single cell is constituted by a MOSFET (metal-oxide-semiconductor field effect transistor) in which the gate electrode includes an additional electrode (floating gate) placed between the channel and the control electrode (control gate), completely electrically insulated from the neighbourhood and separated by a dielectric from the control gate.

The information stored in the cell is represented by the charging state of the gate electrode, that is modified by either injecting electrons from the FET into the floating gate (writing) or removing them (erasing).

In absence of relatively high voltages applied to the FET electrodes, the floating gate charge remains almost unaltered in time because the electrons remain in such electrode without disperding into the surrounding environment, thanks to the presence of insulating layers that surround its.

Among the floating gate non-volatile MOS memories, a dominant position is occupied by flash memories, whose main features are given by the possibility of being written and erased electrically, by the random access not only for reading but even for writing, and by the considerable high integration density, due to the presence of a particularly compact single transistor elementary cell.

In flash memories, the mechanism adopted for writing, or programming, a memory cell is the injection into the floating gate of "hot" electrons coming from the channel and "heated" by the application of a suitable potential difference between source and drain.

In a write operation, some ten of thousands of electrons are injected into the floating gate, and the retention thereof inside the floating gate guarantees the memory non-volatility.

The physical mechanism adopted for erasing a flash memory cell, an operation in which the floating gate substantially is emptied of the electrons injected during the writing, is the tunneling through a dielectric of the electrons from the floating gate to the source, made possible by the application of a suitable potential difference between control gate and source.

The efficiency of this charge transfer process is measured by the capacitive coupling between control gate and floating gate, that is expressed in terms of a capacitive coupling coefficient $\alpha_G$, defined as the ratio between the capacitance $C_{CG}$ of the control gate and the total capacitance $C_{TOT}$ associated with the gate electrode, that also takes into account the capacitive couplings due to the presence of the source $C_S$, of the drain $C_D$, of the tunnel oxide and of the channel $C_{FG}$ :

$$\alpha_G = C_{CG} / C_{TOT} = C_{CG} /(C_{CG} + C_{FG} + C_S + C_D).$$

According to a model widely in use, the sequence of control gate/dielectric/floating gate layers can be represented as a capacitor with plane and parallel plates separated by a dielectric, the floating gate and the control gate being the two plates thereof.

The capacitive coupling coefficient $\alpha_G$ is thus proportional to the capacitance

$$C_{CG} = \varepsilon_{diel} (A_{FG}/T_{diel})$$

where $\varepsilon_{diel}$ is the dielectric constant of the dielectric, $A_{FG}$ is the area of the floating gate surface facing the control gate, and $T_{diel}$ is the dielectric thickness.

Consequently, the capacitive coupling coefficient $\alpha_G$ strongly depends on the shape and the size of the floating gate and, in particular, it is proportional to the floating gate surface area facing the control gate.

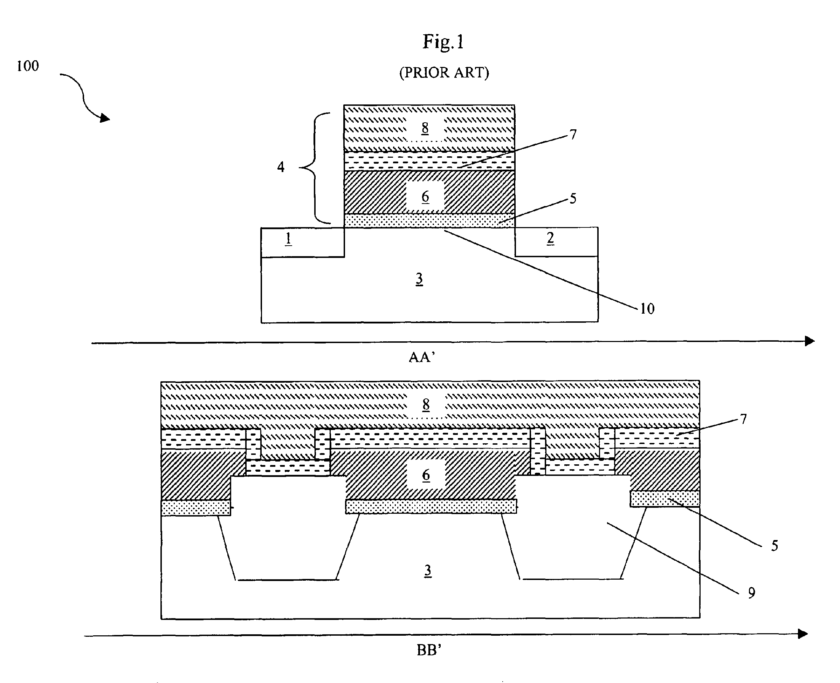

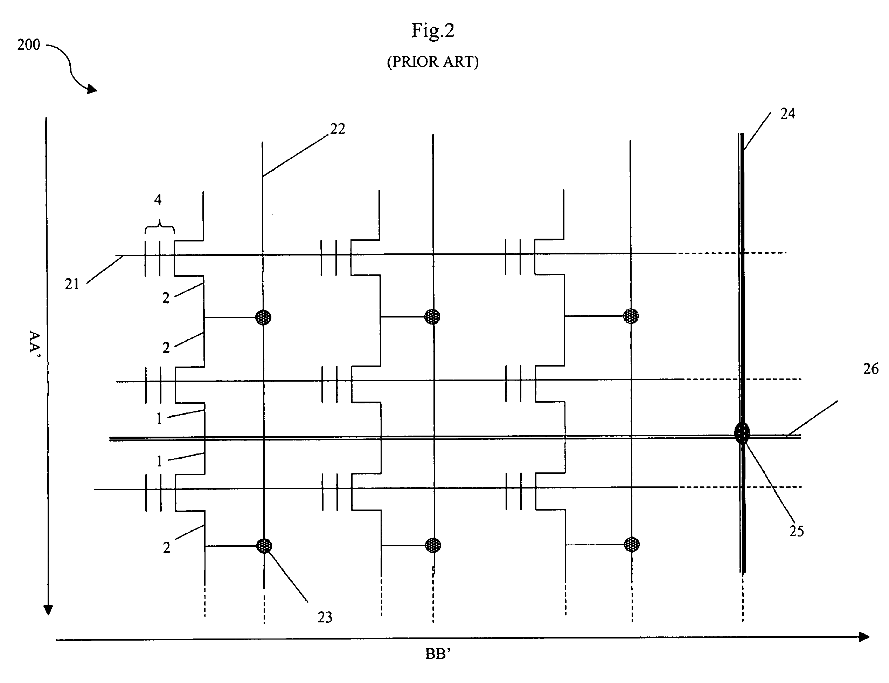

In Figures 1 and 2 there are shown, in simplified way, respectively a cross section and a circuit scheme of a portion of a matrix 200 of flash memory cells, such cross section being taken along a direction AA' and along a direction BB' perpendicular thereto.

Figure 1 evidences the layered structure of the gate electrode region 4, the wells of the source region 1 and drain region 2, and the central electrically active region 10, formed by the FET channel within a silicon single crystalline substrate 3.

Over the FET channel 10 the central region is constituted by:

- a first thin dielectric layer 5, typically silicon oxide, called tunnel oxide;

- the floating gate 6, usually formed by a heavily doped polycrystalline silicon layer;

- a second dielectric layer 7, made for example of a succession of $SiO_2/Si_3N_4/SiO_2$ thin layers called ONO (acronym for oxide-nitride-oxide), that covers the floating gate 6;

- the control gate 8, typically formed of heavily doped polycrystalline silicon layer.

Along the direction BB', the memory cells 100 are separated by insulating regions 9, that in the currently more advanced technologies are of STI (shallow trench isolation) type, i.e., they are constituted by trenches in the single crystalline silicon substrate 3, filled up by one or more dielectric layers.

Typically, the memory cells 100 are organized in a matrix structure, that, as shown by way of example in Figure 2 for a NOR matrix 200 of flash type memory cells 100, is arranged in rows 21, called word lines, running along the direction BB', and columns 22, called bit lines, running along the direction AA'.

In the matrix 200 the control gates 8 of the memory cells 100 form the word lines 21, and along this direction source connection lines 24, constituted by semiconductor material, extend in regular intervals, for example every 16 cells, running parallel to the bit lines 22.

The bit lines 22, that constitutes the drain connection lines, are formed by conductor material, typically a metal or an alloy of one or more metals (for example Al, AlCu, Cu, W...) and run perpendicularly to the word lines 21.

In the direction of the bit lines 22, the drains 2 of adjacent memory cells 100 face each other, and in correspondence of each pair of faced drains 2 drain electric contacts 23 are provided along the bit lines 22, connecting the drains 2 to the bit lines 22.

Also the sources 1 of adjacent memory cells 100 face each other in the direction of the bit lines 22, and the diffusion source lines 26 connect them to source connection lines 24 by means of source electric contacts 25, along the direction of the word lines 21.

A conventional process for fabrication of flash memories the calls for the formation of the isolation regions 9, for example of STI type, and of the floating gates 6 of the memory cells 100 through the following phases:

1. On the single crystalline silicon substrate 3, a sufficiently thin dielectric layer is grown, of thickness ranging from 10 to 20nm, called pad oxide;

2. On the pad oxide, a silicon nitride layer of thickness typically ranging from 100nm to 200nm is deposited, that has the function of stop layer for the following planarization treatments;

3. The areas where the STI type isolation regions 9 will be made are defined by lithography;

4. The nitride layer and the pad oxide are removed in sequence from these areas, and trenches of the desired depth, typically about 150nm, are formed inside the single crystalline silicon bulk 3;

5. The trenches are filled with one or more layers of dielectric material, that as a whole are called field oxide;

6. The field oxide is planarized, typically using the CMP (chemical mechanical polishing) technique, in such a way as its exposed surface is flush with that of the still present nitride portion;

7. The exposed field oxide surface level is lowered, typically by a wet etch in hydrofluoric acid (HF), so that at the end of the process the height difference between the field oxide surface and the surface of the single crystalline silicon substrate 3 is not too high (~20nm).

After having formed in this way the STI type isolation regions 9, the process of formation of the floating gates 6 of the memory cells 100 proceeds with the following phases:

8. The portion of nitride still present is removed;

9. A sacrificial dielectric layer called sarox is grown, of thickness approximately equal to 10nm,;

10. Through the sarox layer, some phases of dopant implantation are performed, necessary to the operation of the memory cell 100;

11. The sarox layer and the pad oxide layer are removed by wet etching;

12. The tunnel oxide 5 is grown, of thickness ranging from 5nm to 10nm;

13. A polycrystalline silicon layer is deposited, of about 100nm thickness;

14. The polycrystalline silicon layer is defined by lithography and etching, so as to form the floating gate 6 of the memory cell 100;

15. The layer of ONO (oxide-nitride-oxide) 7 is deposited, covering the floating gate 6;

16. The control gate 8 is formed, typically made of heavily doped polycrystalline silicon.

In the last generation technologies the memory cells dimensions 100 are so small that the use of the traditional lithography for the definition of the floating gate 6 results critical. In fact, a possible misalignment, even minimum, in the lithographical definition phase (14) of the polycrystalline silicon layer, would result too high for so small geometries, and it would prevent from correctly defining the memory cell 100.

On the other hand, the request of reduction of the memory dimensions becomes more and more pressing with the technological progress, and this demand translates into the necessity of devising technological solutions and innovative integrated structures that allow combining in such devices an optimal electric behavior with minimal geometric dimensions.

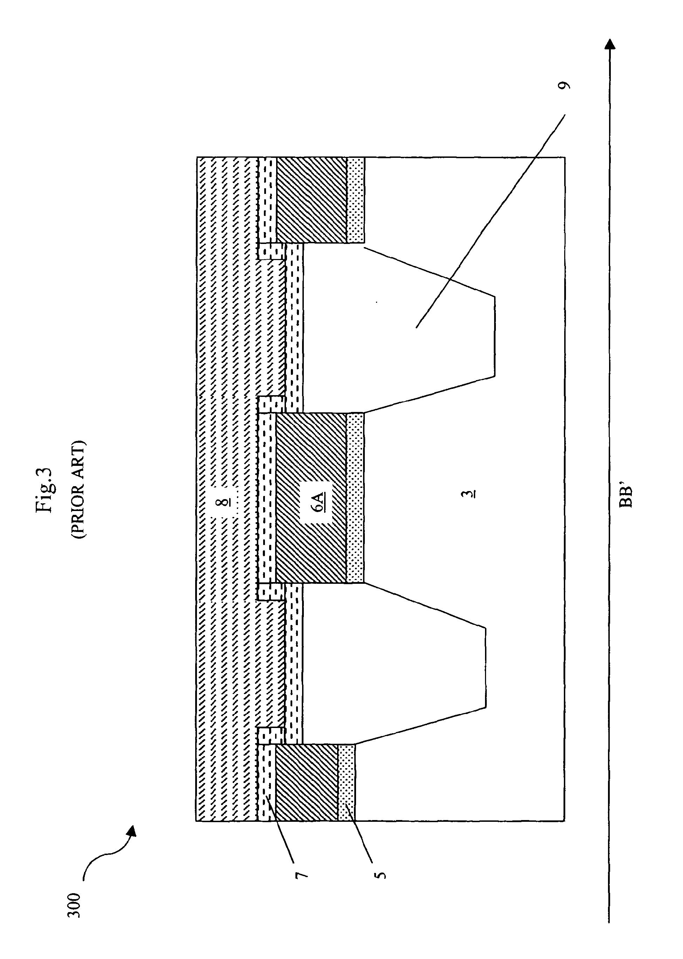

Therefore, the possibility has been investigated of making a memory cell with self-aligned insulation, so called because the electrically active regions and the floating gate are defined simultaneously. The floating gate thus results automatically aligned to the isolation regions. An example of flash memory cell 300 with self-aligned insulation, is shown in Figure 3 in schematic transversal section along the direction BB', not in scale and limitedly to the layers of interest. Along the direction AA', the flash memory cell 300 has a structure similar to the memory cell 100 shown in Figure. 1.

In detail, the solution with self-aligned insulation provides for forming isolation regions 9, for example of STI type, and the floating gates 6A of the memory cells 300 trough the following phases:

1A. The tunnel oxide 5 is grown on the single crystalline substrate 3;

2A. A polycrystalline silicon layer, forming the floating gate 6A, of thickness about of 200nm is deposited;

3A. A silicon nitride layer of thickness typically ranging from 100nm to 200nm, having the function of stop layer for the following planarization treatments, is deposited;

4A. The STI type isolation regions are defmed by lithography and etch of the sequence of silicon nitride layer, the polycrystalline silicon layer, the tunnel oxide 5 layer and single crystalline substrate 3, up to formation of trenches of desired depth, typically about of 150nm, inside the single crystalline silicon substrate 3.

The floating gates 6A thus defined are self-aligned to the type STI isolation regions.

5A. The trenches are filled with the field oxide;

6A. The field oxide is planarized, typically using the CMP (chemical mechanical polishing) technique, in such a way that the exposed surface thereof is flush with that of the silicon nitride layer.

7A. The silicon nitride layer is removed by isotropic etching;

8A. The level of the exposed surface of the field oxide is lowered, typically by wet etching in hydrofluoric acid (HF), in such a way to uncover the side walls of the floating gate 6A.

9A. The ONO (oxide-nitride-oxide) layer 7, covering the floating gate 6, is deposited;

10A. The control gate 8, typically made of heavily doped polycrystalline silicon, is formed.

Since in this way the floating gate 6A is automatically aligned to the STI type isolation regions 9, this process flow allows obtaining memory cells 300 of reduced dimensions compared to the memory cells 100 made with the traditional process flow.

Regretfully, for an equal thickness of deposited polycrystalline silicon, this last generation process flow produces floating gates 6A of such a morphology that strongly reduces the capacitive coupling coefficient $\alpha_G$ between the floating gate 6A and the control gate 8.

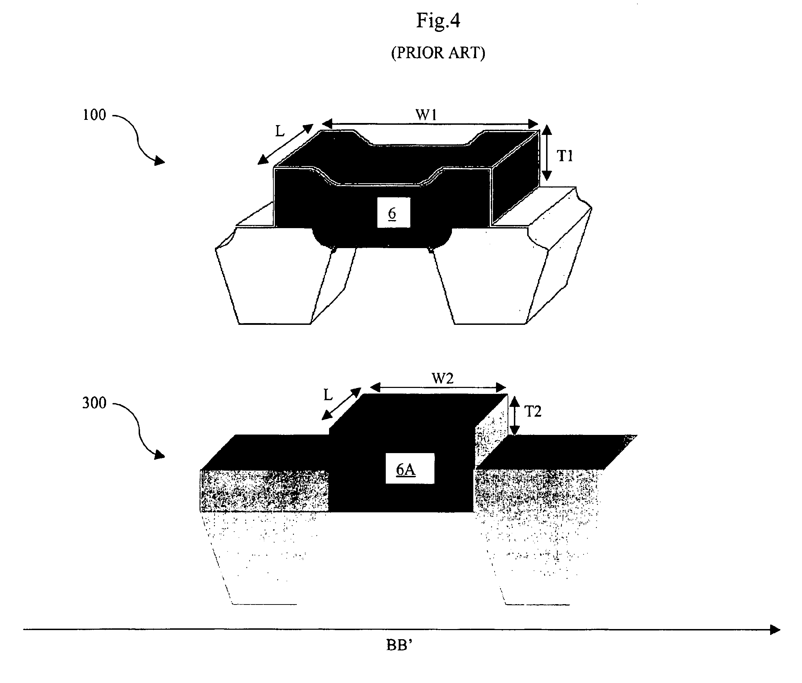

In fact, comparing the morphology of the traditional floating gate 6 of the memory cell 100 with that of the floating gate 6A of the memory cell 300 with self-aligned insulation, represented in Figure 4, it can be noticed that the traditional floating gate 6 has some protuberances, so-called "wings", that extend over the adjacent STI type isolation regions 9. Such wings are instead missing in the case of the floating gate 6A of the memory cell 300 with self-aligned insulation.

The lack of these "wings", due to the complex of the process phases that are used for the realization of the floating gate 6A, causes the width W2 of the floating gate 6A to be lower than the width W1 of the traditional floating gate 6.

Besides, also the effective thickness T2 of the floating gate 6A is lower than that of the traditional floating gate 6, indicated with T1.

This difference is due to the fact that in the process flow realizing the floating gate 6A the lowering phase of the level of the exposed field oxide surface (8A) is performed after the growth phase (1A) of the tunnel oxide 5. Therefore a margin, of the order of the about ten nanometers, is required in the lowering phase (8A) of the exposed field oxide surface (14B) so as to guarantee the preservation of the tunnel oxide 5.

Accordingly, the side walls of the floating gate 6A are partially covered by field oxide, and therefore the effective thickness T2 of the floating gate 6A is lower than the effective thickness T1 of the traditional floating gate 6.

These differences in the geometric dimensions of the floating gate 6 and 6A are reflected in the values of the capacitive coupling coefficients $\alpha_G$ of the traditional memory cells 100 and 300 with self-aligned insulation, whose ratio is expressed by the relationship:

$$\alpha_G(300)/ \alpha_G(100) \doteq (W2+2T2)/(W1+2T1)$$

from which it can be deduced that, being W2 and T2 lower than W1 and T1, the capacitive coupling coefficient $\alpha_G$ (300) of the memory cell 300 with self-aligned insulation is lower than the corresponding capacitive coupling coefficient $\alpha_G$ (100) of the traditional memory cell 100.

It has been verified experimentally that this difference can be estimated to be of order of 10% at least.

Such an efficiency loss in the capacitive coupling $\alpha_G$ leads to an increase in the erasing time of the memory cell 300 with self-aligned insulation, since the charge transfer process from the floating gate 6A to the source region 1 is less efficient, and makes it essential to reach a higher final erase voltage.

The management of high erase voltages is burdensome and can cause phenomenons of degradation of the quality of the active oxides, worsening the characteristics of reliability of the memory cell 300 with self-aligned insulation, whose electric performances result accordingly limited.

The formation of the floating gate 6A starting from a thicker deposited polycrystalline silicon allows partially recovering the loss of capacitive coupling between floating gate and control gate, but this introduces other problems; in particular, the filling by field oxide of the isolation trenches becomes critical because of the increased depth of the trench to be filled.

The technical problem that is at the base of the present invention, is therefore to devise a method for obtaining a floating gate non-volatile MOS memory device, that has very small geometric dimensions, and in which the memory cells have a capacitive coupling coefficient $\alpha_G$ between control gate and floating gate higher than that obtainable according to the state of the art, overcoming the limitations and the drawbacks that still limit the devices of this type made according to the prior art.

Such a technical problem is solved by forming a U-shaped floating gate non-volatile semiconductor memory device.

United States patent 6153472 (Ding et al) describes a method of fabricating a flash memory with a U-shaped floating gate which involves forming a tunnelling oxide layer, a polysilicon layer, and a silicon nitride layer on a semiconductor substrate. A trench is formed in the layers and is filled up to the level of the silicon nitride layer. The silicon nitride layer is then removed to expose the polysilicon layer and a portion of each side wall of a shallow trench isolation structure. A polysilicon spacer is formed on each exposed side wall of the shallow trench isolation structure. An upper portion of this structure is removed so as to expose a portion of each side wall of the polysilicon layer. The polysilicon layer serves as a floating gate. A conformal dielectric layer and a top polysilicon layer are formed over the substrate. The top polysilicon layer, the dielectric layer, and the polysilicon layer are patterned to form a strip control gate, which covers the floating gate.

Published patent application US 2003/0077907 (Kao et al) describes a method of fabricating a semiconductor device with a U-shaped floating gate comprising the steps of forming a polycrystalline silicon layer over a semiconductor substrate assembly and forming a silicon nitride layer over the polycrystalline silicon layer. A silicon dioxide layer is formed over the silicon nitride layer and the silicon dioxide and silicon nitride layers are patterned using a patterned mask having a width, thereby forming sidewalls in the two layers. The nitride and oxide layers are subjected to an oxygen plasma which treats the sidewalls and leaves a portion of the silicon nitride layer between the sidewalls untreated. The silicon dioxide and the untreated portion at the silicon nitride layer are removed thereby resulting in pillars of treated silicon nitride. Finally, the polycrystalline silicon is etched using the pillars as a mask. The patterned polycrystalline silicon layer thereby comprises features having widths narrower than the width of the original mask.

According to the invention as defined in claim 1, and with the preferred features defined in the following claims, an improved method of manufacturing a U-shaped floating gate non volatile MOS semiconductor memory device is disclosed.

The features and advantages of the proposed invention will result clear by the detailed description of some embodiments thereof that is done in the following, and by the drawings that accompany the text, where:

-    In Figure 1 there is shown in schematic transversal section a flash memory cell according to the prior art, along two perpendicular directions AA' and BB';

-    In Figure 2 a circuit diagram of a portion of a typical matrix structure of flash NOR memory cells according to the prior art is shown;

-    In Figure 3 a flash memory cell with self-aligned insulation according to the prior art is shown, in schematic transversal section, along the direction BB';

-    In Figure 4 there is shown in perspective view the comparison between the morphology of the transversal section of a flash memory cell with self-aligned insulation and that of a traditional memory cell, according to the prior art, along the direction BB';

-    In Figure 5 there is shown, in schematic transversal section and limitedly to the layers of interest, a non-volatile MOS memory cell with floating gate with self-aligned insulation according to an embodiment of the invention, along the direction BB';

-    Figures 6A-6D show, in transversal section along the direction BB' and in schematic way, some phases of a method of making a non-volatile MOS memory device with floating gate with self-aligned insulation, according to an embodiment of the invention;

-    Figures 7A-7E show, in transversal section along the direction BB', and in schematic way, a sequence of phases of a method of making a non-volatile MOS memory device with floating gate with self-aligned insulation according to a first embodiment of the invention;

-    Figures 8A-8D show, in transversal section along the direction BB' and in schematic way, a sequence of phases of a method of making a non-volatile MOS memory device with floating with self-aligned insulation to STI type isolation regions according to a second embodiment of the invention;

A method of making a non-volatile MOS memory device with floating gate with self-aligned insulation, according to an embodiment of the invention will be now described.

Particularly, the case of a flash type non-volatile MOS memory device with floating gate with self-aligned insulation is considered by way of example.

The example does not constitute a limitation of the present invention, that can be applied also to different types of non-volatile MOS memory devices with floating gate that use a self-aligned insulation scheme.

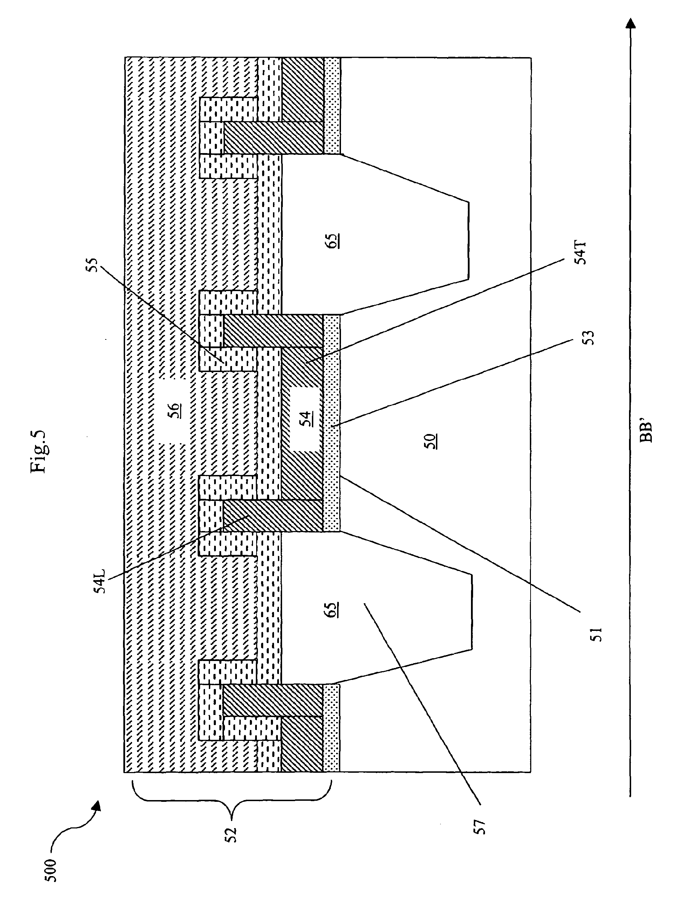

With reference to Figure 5, an example of flash type memory cell 500 inside a non-volatile MOS memory device, obtained according to an embodiment of the invention, is represented in schematic transversal section and limitedly to the layers of interest along the direction BB', and includes an electrically active region 51 inside a single crystalline silicon substrate 50, surmounted by a layer structure that constitutes the gate electrode region 52.

The gate electrode region 52 includes:

- a first thin dielectric layer 53, typically silicon oxide, called tunnel oxide;

- the floating gate 54, including a first conductor material layer, for example heavily doped polycrystalline silicon;

- a second dielectric layer 55, for example constituted by a $SiO_2/Si_3N_4/SiO_2$ layers sequence called ONO (oxide-nitride-oxide), that covers the floating gate 54;

- the control gate 56, formed by a second conductor material layer, for example heavily doped polycrystalline silicon.

Along the direction BB', direction along which the word lines extend, adjacent memory cells 500 are separated by STI (shallow trench isolation) type isolation regions 57.

According to an embodiment of the invention, the floating gate 54 advantageously takes a concave, generically saddle shape. Particularly, the floating gate 54 includes a base wall 54T and side walls 54L, of shape and thickness such as to cause the floating gate 54 exhibit a concavity facing upward that makes the floating gate take a generically "U" shape. This characteristic of the floating gate 54 allows obtaining a gate capacitive coupling $\alpha_G$ of the memory cell 500 higher compared to the prior art, and it favors a reduction of the reading disturbs associated with the capacitive couplings between the floating gates 54 of adjacent memory cells 500.

Particularly, according to a preferred embodiment of the invention, said side walls 54L protrude from said base wall 54T of a height equal to at least 5 times the thickness of said base wall 54T.

The structure just described can be obtained according to an embodiment of the invention by the process flow that is described in the following, that is limited to the description of the process phases of interest for the understanding of the method according to the invention, and is not exhaustive of a process flow suitable to obtain an integrated memory device according to well known techniques.

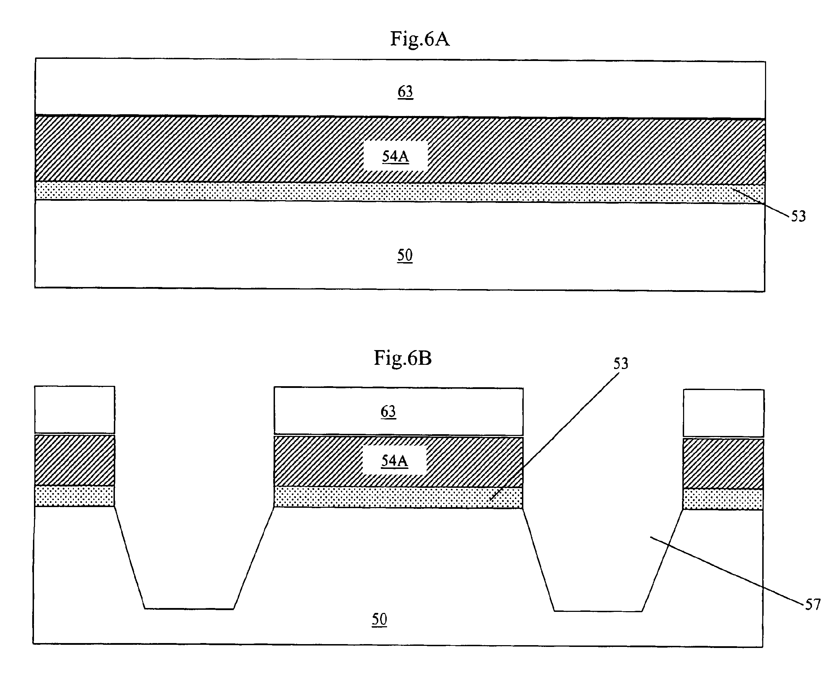

With reference to Figures 6A-6D, an embodiment of the proposed innovative solution includes the following process phases for the formation of memory cells 500 with self-aligned insulation:

1. The tunnel oxide 53, of thickness preferable ranging from 5nm to 10nm, is grown on the single crystalline silicon substrate 50 (Figure 6A);

2. A conductor material layer 54A is deposited, for example heavily doped polycrystalline silicon, of thickness ranging from 50nm to 150nm, preferably 100nm, from which will be obtained the floating gate 54 of the memory cell 500 (Figure 6A);

3. A silicon nitride layer 63 of thickness ranging from 100nm to 200nm, having the function of stop layer for the following planarization treatments, is deposited (Figure 6A);

4. The insulation regions 57, for example of STI type, are defined by lithography and etching of the silicon nitride 63, conductor material 54A, tunnel oxide 53 and single crystalline substrate 50 layers sequence, up to forming inside the single crystalline substrate 50 trenches of desired depth, for example about of 150nm (Figure 6B).
The conductor material layer 54A thus defined is self-aligned with the type STI isolation regions 57.

5. The trenches are filled with one or more layers of dielectric material, that in their complex take the name of field oxide 65 (Figure 6B);

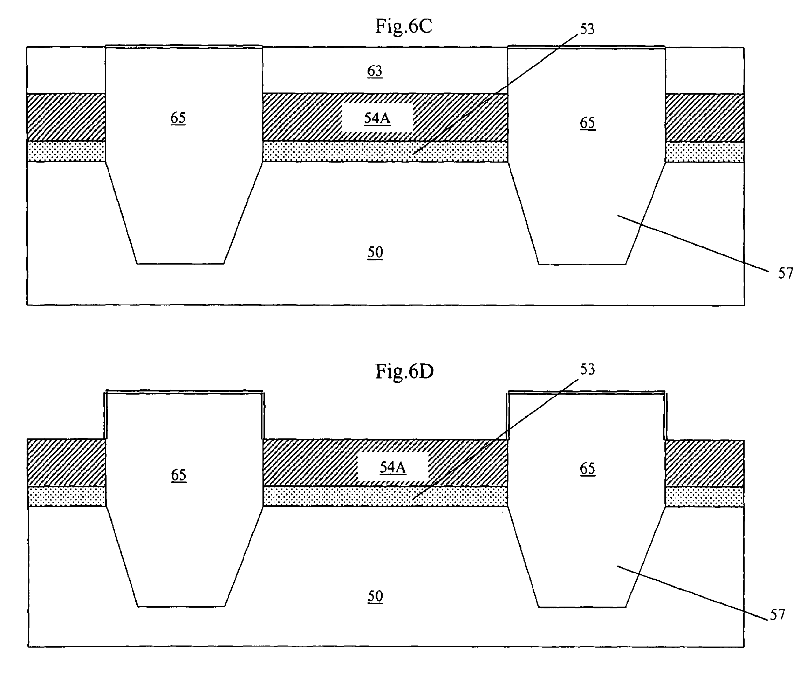

6. The field oxide 65 is planarized, using for example the CMP (chemical mechanical polishing) technique, so that its exposed surface is flush with that of the still present silicon nitride portion 63 (Figure 6C).
After having formed in this way the STI isolation regions 57, the process of formation of the floating gates 54 self-aligned to the STI isolation regions 57 proceeds with the following phases:

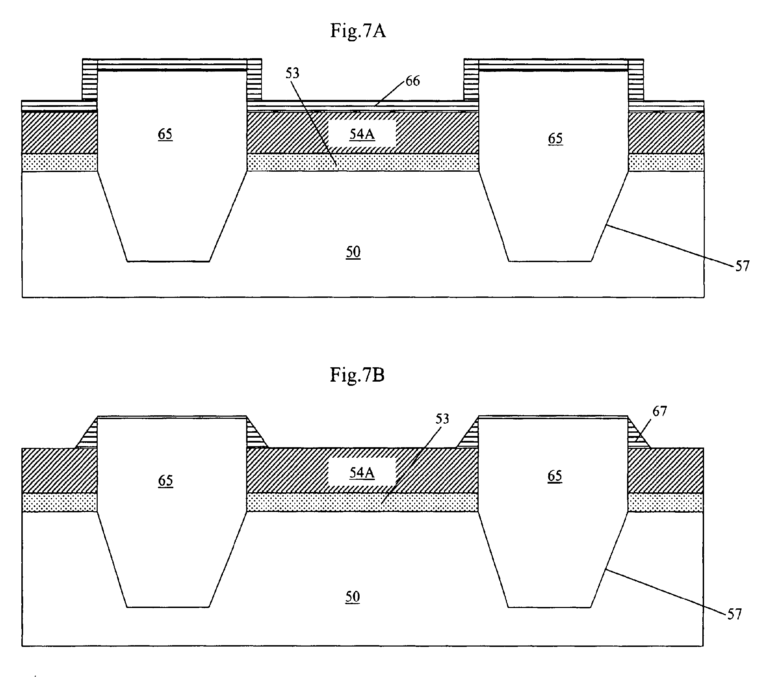

7. The portion of silicon nitride 63 still present is removed (Figure 6D);
After the removal phase (7) of the portion of the still present silicon nitride layer 63, a first embodiment of the method according to the invention proposes advantageously the following process phases, shown in Figures 7A-7E:

8. A dielectric layer 66, for example silicon oxide or silicon nitride, of thickness such as to result conformal, that is substantially following the profiles of the underlying layers is deposited. The thickness of the dielectric layer 66 is preferably ranging from 5nm to 15nm (Figure 7A);

9. The dielectric layer 66 just deposited is anisotropicly etched, through an etch composition that is selective with respect to the conductor material of the layer 54A. If for example the layer 54A includes heavily doped polycrystalline silicon, etch compositions can be used that are based on oxygen and fluorine carbides as $C_4F_6$, $CF_4$, $C_4F_8$. In such a way, dielectric "spacers" 67 are defined above the conductor material layer 54A, at the sides of the field oxide 65 (Figure 7B);

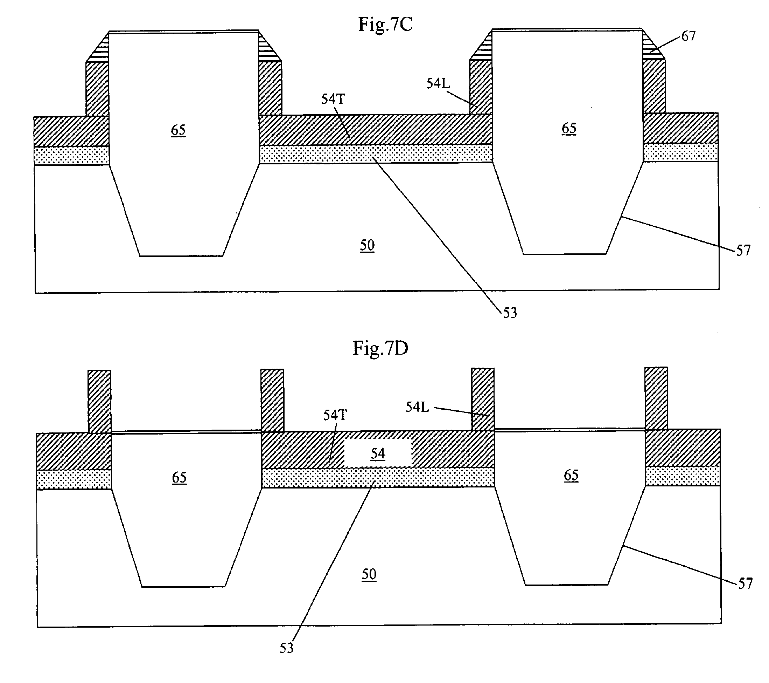

10. Exploiting the presence of the just defined dielectric "spacers" 67, the level of the conductor material layer 54A is lowered through an anisotropic etch that is selective with respect to the dielectric of which the "spacers" 67 are constituted. Such etch for example uses an etch composition based on oxygen and chlorine or based on oxygen and bromidic acid. The formation of the floating gate 54 is thus completed; the floating gate takes the concave saddle shape defined above, with base wall 54T and side walls 54L (Figure 7C). Advantageously, in such a way it is the thickness of a deposited layer, and not a lithography operation, defines the thinness of the side walls 54L, therefore, thanks to the invention, very thin side walls 54L can be obtained, of about 30nm or even less.

11. The dielectric "spacers" 67 are removed through an isotropic etch that is selective with respect to the conductor material of which the floating gate 54 is formed, for example heavily doped polycrystalline silicon. In the case of removal of silicon oxide, an etch in hydrofluoric acid (HF) is for example used, in the case of removal of silicon nitride, an etch in phosphoric acid is used (Figure 7D);

12. The level of the field oxide 65 exposed surface is lowered through a wet etching, for example in hydrofluoric acid (HF), set in such a way to uncover the side walls 54L of the floating gate 54 (Figure 7D). If the material of which the "spacers" 67 are formed is the same of the field oxide 65, the wet etching performed in this phase advantageously includes also the removal of the "spacers" 67 indicated in point 11;

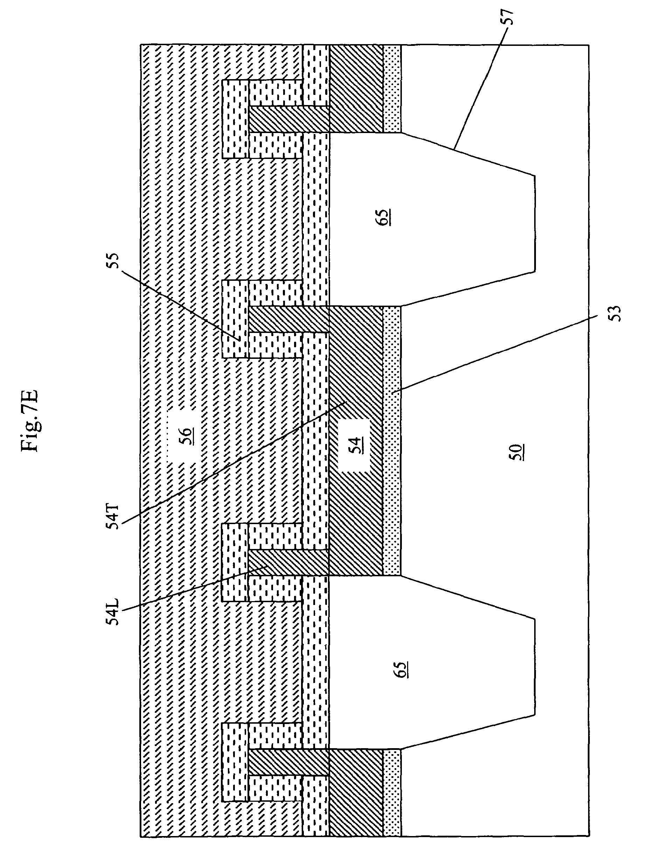

13. The dielectric layer 55 is deposited, for example ONO (oxide-nitride-oxide), covering the floating gate 54 (Figure 7E);

14. The control gate 56 is formed, for example made of heavily doped polycrystalline silicon (Figure 7E).

The process continues from now on according to a traditional scheme, with the definition of the gate electrode through anisotropic etching of the control gate 56, dielectric 55 and floating gate 54 layers sequence, followed by the known complex of operations that lead to the realization of the finished memory device.

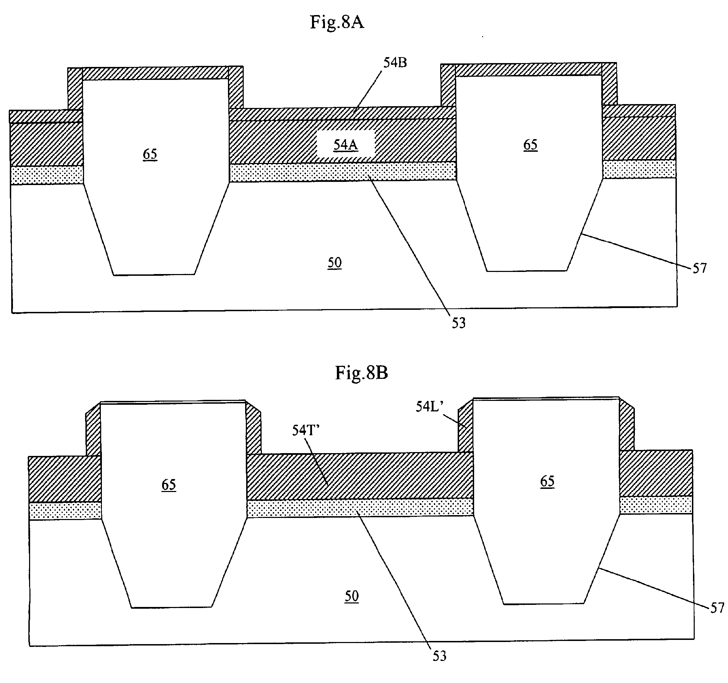

In alternative to the sequence of process phases just described, a second embodiment of the method according to the invention proposes, in the deposition phase (2) of the layer 54A, the deposition of a lower thickness of conductor material, preferably ranging from 30nm to 40nm. Besides, the second embodiment of the method according to the invention proposes, after the removal phase (7) of the layer of silicon nitride 63, the following process phases, shown in schematic way in Figures 8A-8D:

8A. A conformal conductor material layer 54B is deposited, in such a way to substantially follow the profile of the underlying layers. The conformal layer 54B is preferably of the same material as the layer 54A deposited before, for example heavily doped polycrystalline silicon. The conformal layer 54B of conductor material preferably has a thickness ranging from 5nm to 15nm, and is short-circuited with the layer 54A of conductor material previously deposited, that forms the base wall 54T of the floating gate 54 (Figure 8A); 9A. The conformal layer 54B just deposited is etched through an anisotropic selective etch with respect to the field oxide 65, up to uncover the surface of the field oxide 65, in such a way to form the side walls 54L' of the floating gate 54 (Figure 8B).

The floating gate 54 thus formed takes the concave saddle shape defined above, with base wall 54T formed by the remaining portion of the conductor material layer 54A and side walls 54L' formed by the remaining portions of the conformal layer 54B. Advantageously, in this way the thickness of a deposited layer, and not a lithography operation, defines the thinness of the side walls 54L', therefore, thanks to the invention, very thin side walls 54L' can be obtained, about of 30nm or less too.

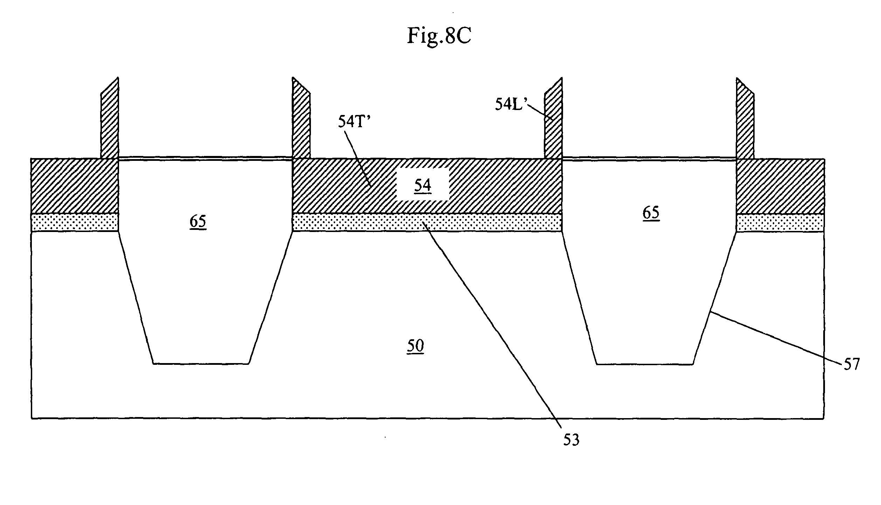

13A. The level of the exposed field oxide surface 65 is lowered, by a wet etching, for example in hydrofluoric acid (HF), in such a way to uncover the side walls 54L of the floating gate 54 (Figure 8C);

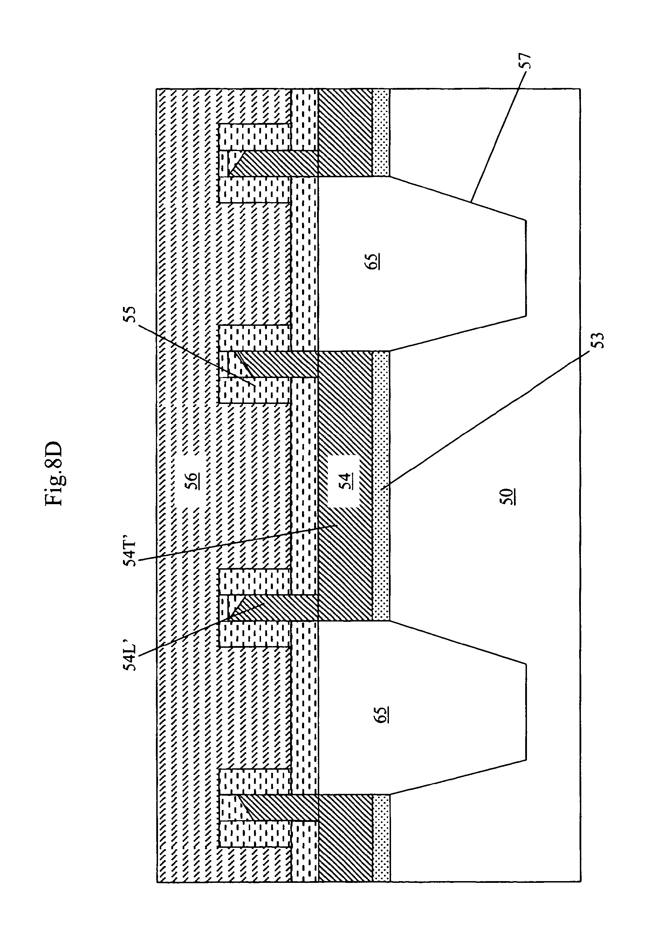

14A. The dielectric layer 55 is deposited, for example ONO (oxide-nitride-oxide), covering the floating gate 54 (Figure 8D);

15A. The control gate 56 is formed, made for example of heavily doped polycrystalline silicon (Figure 8D).

The process proceeds from now on according to a traditional scheme, with the definition of the gate electrode by anisotropic etch of the control gate 56, dielectric 55 and the floating gate 54 layers sequence, followed by the complex of known operations that lead to the fabrication the finished memory device.

By the method just described, the invention makes a floating gate non-volatile semiconductor memory device of very reduced geometric dimensions, typical of memory devices with self-aligned insulation, in which nevertheless the memory cells advantageously possess a capacitive coupling coefficient $\alpha_G$ higher than that obtainable according to the prior art, overcoming the limitations and the drawbacks that limit the known devices of this type.

In fact, thanks to the method according to the invention, and particularly to the floating gate shape, the portion of floating gate surface that faces the control gate is greater than that obtainable according the prior art.

Accordingly, being the capacitive coupling coefficient $\alpha_G$ directly proportional to the area of the floating gate surface facing the control gate, its value, thanks to the method according to the invention, is greater than that obtainable by known methods.

Such a higher value of the capacitive coupling coefficient $\alpha_G$ significantly improves the efficiency of the programming and erasing operations of the memory cells, thus overcoming the problems present in memory devices made according to the known principles.

Advantageously, the method according to the invention allows obtaining a higher value of the capacitive coupling coefficient $\alpha_G$ without the addition of lithographic phases, that can produce misalignments and dimensional problems.

Besides, the method according to the invention allows making a floating gate non-volatile semiconductor memory device in which the parasitic capacitive coupling between adjacent memory cells advantageously results reduced with respect to that obtainable according to the prior art.

This important advantage is due to the fact that operating in the way proposed by the invention, the floating gate that is obtained, thanks to the peculiar concave saddle shape, possesses side walls of lower area than the devices made according to the prior art.

In fact, based on the model of a capacitor with plane and parallel plates, the parasitic capacitive coupling between adjacent memory cells, particularly in the direction AA' along which the bit lines extend, is directly proportional to the area of the walls of the floating gates of adjacent cells facing each other.

Since according to the method of the invention it is advantageously the thickness of a deposited layer, and not a lithography operation, that defines the thinness of the side walls of the floating gate, the invention allows making the side walls of floating gates of adjacent memory cells of very reduced thickness, if desired thinner than the base wall, thereby allowing to make adjacent memory cells with reduced parasitic capacitive coupling.

This peculiarity is particularly advantageous in the case the method according to the invention is applied to NAND flash type floating gate non-volatile semiconductor memory devices, in which the disturbs due to the parasitic capacitive coupling between adjacent memory cells currently represent one of the causes of variation of the threshold voltage in the memory cell matrixes.

Besides, it is particularly useful applying the method according to the invention devices to multilevel flash memories, in which the reduced threshold variation margins between the different programming states make the correct operation of the memory cells particularly critical in the presence of a high parasitic capacitive coupling between adjacent memory cells.

The method according to the invention is therefore very advantageous in the case of NOR or NAND flash type or multilevel floating gate non-volatile semiconductor memory devices, but it can be applied to any semiconductor memory device in which it is necessary to have a wide coupling area between the floating gate and any other electrode.

**Claims**

1. Method of making a non-volatile MOS semiconductor memory device including a phase of formation, in a semiconductor material substrate (50), of STI isolation regions (57) filled with field oxide (65) and of memory cells (500) separated one from the other by said isolation regions (57), said memory cells (500) including an electrically active region (51) surmounted by a gate electrode (52), electrically insulated from said substrate (50) of semiconductor material by a first dielectric layer (53), said gate electrode (52) including a substantially "U" shaped floating gate (54) simultaneously defined with said electrically active region (51), the method comprising a formation phase of said floating gate (54) including:

   - the formation of a base wall (54T) and of side walls (54L) belonging to said floating gate (54), said side walls (54L) protruding from said base wall (54T) in proximity of said STI isolation regions (57);
   - a first deposition phase of a first conductor material layer (54A);
   - a phase of simultaneous definition of said first conductor material layer (54A) and of said isolation regions (57), and subsequent filling of said isolation regions (57) with said field oxide (65);
   - a second deposition phase of a conformal material layer above said first conductor material layer (54A) and said isolation regions (57), said second deposition phase including the deposition of a second dielectric layer (66),
- the method being **characterized by** including, following said deposition of said dielectric layer (66), the following phases:

> - a definition phase of "spacers" (67) of said second dielectric layer (66) above said first conductor material layer (54A), through a first anisotropic etch of said second dielectric layer (66);
> - a lowering phase of said first conductor material layer (54A), through a second anisotropic etch of said first conductor material layer (54A), in such a way to make said floating gate (54) with a U shape.
> - a removal phase of said "spacers" (67), through a first isotropic etch.

2. Method according to claim 1, **characterized in that** said second dielectric layer (66) has a thickness ranging from 5nm to 15nm, preferably 10nm.

3. Method according to claim 1 or 2, **characterized in that** said second dielectric layer (66) includes silicon oxide or silicon nitride.

4. Method according to claim 1, **characterized in that** said first anisotropic etch and said first isotropic etch include using an etch selective composition with respect to said first conductor material layer (54A).

5. Method according to claim 1, **characterized in that** said second anisotropic etch includes the use of an etch composition selective with respect to said second dielectric layer (66).

6. Method according to claim 1, **characterized in that** said second deposition phase includes the deposition of a second conductor material layer (54B).

7. Method according to claim 6, **characterized by** further including an anisotropic etch phase of said second conductor material layer (54B) and of said first conductor material layer (54A), in such a way to make said floating gate (54) with a U shape.

8. Method according to claim 6, **characterized in that** said second conductor material layer (54B) includes the same conductor material as said first conductor material layer (54A).

9. Method according to claim 6 or 8, **characterized in that** said second conductor material layer (54B) includes doped or non doped heavily polycrystalline silicon.

10. Method according to claim 6 or 9, **characterized in that** said second conductor material layer (54B) has a thickness ranging from 5nm to 15nm.

11. Method according to claim 7, **characterized in that** said anisotropic etch includes the use of an etch composition selective with respect to said field oxide (65).

12. Method according to claim 1 or 7, **characterized by** including, after said formation phase of said floating gate (54), the following phases:

> - a lowering phase of the exposed surface of said isolation regions (57), in such a way to uncover said side walls (54L) of said floating gate (54);
> - a formation phase of a control gate (56) electrically insulated from said floating gate (54) through a third dielectric layer (55).

13. Method according to claim 12, **characterized in that** said lowering phase includes a wet etching, particularly in presence of hydrofluoric acid (HF).

14. Method according to any one of claims 1 to 5 or 12, **characterized in that** said first conductor material layer (54A) has a thickness in the range from 30nm to 150nm.

15. Method according to any one of claims from 6 to 12, **characterized in that** said first conductor material layer (54A) has a thickness in the range from 30nm to 40nm.

**16.** Method according to any one of the preceding claims, **characterized in that** said first conductor material layer (54A) includes doped or non doped polycrystalline silicon.

**17.** Method according to any one of the preceding claims, **characterized in that** said isolation regions (57) are STI type (shallow trench isolation).

**Patentansprüche**

**1.** Verfahren zur Herstellung eines nichtflüchtigen MOS-Halbleiter-Speicherbauelementes mit einer Phase zum Bilden, in einem Substrat (50) aus Halbleitermaterial, von mit Feldoxid (65) gefüllten STI-Isotationsregionen (57) und von Speicherzellen (500), die durch die genannten Isolationsregionen (57) voneinander getrennt sind, wobei die genannten Speicherzellen (500) eine elektrisch aktive Region (51) aufweisen, auf der eine Gate-Elektrode (52) montiert ist, die von dem genannten Substrat (50) aus Halbleitermaterial durch eine erste dielektrische Schicht (53) elektrisch isoliert ist, wobei die genannte Gate-Elektrode (52) ein im Wesentlichen "U"-förmiges Floating-Gate (54) aufweist, das gleichzeitig mit der genannten elektrisch aktiven Region (51) definiert wird, wobei das Verfahren eine Phase zum Bilden des genannten Floating-Gate (54) umfasst, die Folgendes beinhaltet:

- Bilden einer Basiswand (54T) und von Seitenwänden (54L), die zu dem genannten Floating-Gate (54) gehören, wobei die genannten Seitenwände (54L) in der Nähe der genannten STI-Isolationsregionen (57) von der genannten Basiswand (54T) vorstehen;
- eine erste Phase zum Auftragen einer ersten Leitermaterialschicht (54A);
- eine Phase zum gleichzeitigen Definieren der genannten ersten Leitermaterialschicht (54A) und der genannten Isotationsregionen (57) und anschließendes Füllen der genannten Isolationsregionen (57) mit dem genannten Feldoxid (65);
- eine zweite Phase zum Auftragen einer konformen Materialschicht über der genannten ersten Leitermaterialschicht (54A) und den genannten Isolationsregionen (57), wobei die genannte Auftragsphase das Auftragen einer zweiten dielektrischen Schicht (66) beinhaltet;
- wobei das Verfahren **dadurch gekennzeichnet ist, dass** es nach dem genannten Auftragen der genannten dielektrischen Schicht (66) die folgenden Phasen beinhaltet:

- eine Phase zum Definieren von "Abstandshaltern" (67) der genannten zweiten dielektrischen Schicht (66) über der genannten ersten Leitermaterialschicht (54A) durch ein erstes anisotropes Ätzen der genannten zweiten dielektrischen Schicht (66);
- eine Phase zum Tieferlegen der genannten ersten Leitermaterialschicht (54A) durch eine zweite anisotrope Ätzung der genannten ersten Leitermaterialschieht (54A) auf eine solche Weise, dass das genannte Floating-Gate (54) eine U-Form erhält;
- eine Phase zum Entfernen der genannten "Abstandshalter" (67) durch eine erste isotrope Ätzung.

**2.** Verfahren nach Anspruch 1, **dadurch gekennzeichnet, dass** die genannte zweite dielektrische Schicht (66) eine Dicke im Bereich von 5 nm bis 15 nm, vorzugsweise von 10 nm hat.

**3.** Verfahren nach Anspruch 1 oder 2, **dadurch gekennzeichnet, dass** die genannte zweite dielektrische Schicht (66) Siliciumoxid oder Siliciumnitrid beinhaltet.

**4.** Verfahren nach Anspruch 1, **dadurch gekennzeichnet, dass** die genannte erste anisotrope Ätzung und die genannte erste isotrope Ätzung die Verwendung einer ätzselektiven Zusammensetzung mit Bezug auf die genannte erste Leitermaterialschicht (54A) beinhaltet.

**5.** Verfahren nach Anspruch 1, **dadurch gekennzeichnet, dass** die genannte zweite anisotrope Ätzung die Verwendung einer Ätzzusammensetzung beinhaltet, die mit Bezug auf die genannte zweite dielektrische Schicht (66) selektiv ist.

**6.** Verfahren nach Anspruch 1, **dadurch gekennzeichnet, dass** die genannte zweite Auftragsphase das Auftragen einer zweiten Leitermaterialschicht (54B) beinhaltet.

**7.** Verfahren nach Anspruch 6, **dadurch gekennzeichnet, dass** es ferner eine Phase des anisotropen Ätzens der genannten Leitermaterialschicht (54B) und der genannten ersten Leitermaterialschicht (54A) auf eine solche Weise beinhaltet, dass das genannte Floating-Gate (54) eine U-Form erhält.

8. Verfahren nach Anspruch 6, **dadurch gekennzeichnet, dass** die genannte zweite Leitermaterialschicht (54B) dasselbe Leitermaterial enthält wie die genannte erste Leitermaterialschicht (54A).

9. Verfahren nach Anspruch 6 oder 8, **dadurch gekennzeichnet, dass** die genannte zweite Leitermaterialschicht (54B) dotiertes oder undotiertes stark polykristallines Silicium beinhaltet.

10. Verfahren nach Anspruch 6 oder 9, **dadurch gekennzeichnet, dass** die genannte zweite Leitermaterialschicht (548) eine Dicke im Bereich von 5 nm bis 15 nm hat.

11. Verfahren nach Anspruch 6, **dadurch gekennzeichnet, dass** die genannte anisotrope Ätzung die Verwendung einer Ätzzusammensetzung beinhaltet, die mit Bezug auf das genannte Feldoxid (65) selektiv ist.

12. Verfahren nach Anspruch 1 oder 7, **dadurch gekennzeichnet, dass** es nach der Phase des Ausbildens des genannten Floating-Gate (54) die folgenden Phasen beinhaltet:

   - eine Phase des Tieferlegens der exponierten Oberfläche der genannten Isolationsregionen (57) auf eine solche Weise, dass die genannten Seitenwände (54L) des genannten Floating-Gate (54) aufgedeckt werden;
   - eine Phase des Ausbilden eines Steuergate (56), das von dem genannten Floating-Gate (54) durch eine dritte dielektrische Schicht (55) elektrisch isoliert ist.

13. Verfahren nach Anspruch 12, **dadurch gekennzeichnet, dass** die genannte Tieferlegphase eine Nassätzung beinhaltet, insbesondere in Anwesenheit von Fluorwasserstoffsäure (HF).

14. Verfahren nach einem der Ansprüche 1 bis 5 oder 12, **dadurch gekennzeichnet, dass** die genannte erste Leitermateriatschicht (54A) eine Dicke im Bereich von 30 nm bis 150 nm hat.

15. Verfahren nach einem der Ansprüche 6 bis 12, **dadurch gekennzeichnet, dass** die genannte erste Leitermaterialschicht (54A) eine Dicke im Bereich von 30 nm bis 40 nm hat.

16. Verfahren nach einem der vorherigen Ansprüche, **dadurch gekennzeichnet, dass** die genannte erste Leitermaterialschicht (54A) dotiertes oder undotiertes polykristallines Silicium beinhaltet.

17. Verfahren nach einem der vorherigen Ansprüche, **dadurch gekennzeichnet, dass** die genannten Isoiationsregionen (57) vom STI-Typ (Grabenisolation) sind.

**Revendications**

1. Un procédé de fabrication d'un dispositif à mémoire à semi-conductcurs MOS non volatile comprenant une phase de formation, dans un substrat de matériau semi-conducteur (50), de zones d'isolation STI (57) remplies d'un oxyde de champ (65) et des cellules mémoire (500) séparées les unes des autres par lesdites zones d'isolation (57), lesdites cellules mémoire (500) comprenant une zone électriquement active (51) surmontée par une électrode de grille (52), électriquement isolée dudit substrat (50) de matériau semi-conducteur par une première couche diélectrique (53), ladite électrode de grille (52) comprenant une grille flottante (54) sensiblement en forme de "U" simultanément définie avec ladite zone électriquement active (51), le procédé comprenant une phase de formation de ladite grille flottante (54) comprenant :

   - la formation d'une paroi de base (54T) et de parois latérales (54L) appartenant à ladite grille flottante (54), lesdites parois latérales (54L) étant en saillie par rapport à ladite paroi de base (54T) à proximité desdites zones d'isolation STI (57),
   - une première phase de dépôt d'une première couche de matériau conducteur (54A),
   - une phase de définition simultanée de ladite première couche de matériau conducteur (54A) et desdites zones d'isolation (57) et un remplissage subséquent desdites zones d'isolation (57) avec ledit oxyde de champ (65),
   - une deuxième phase de dépôt d'une couche de matériau enrobant au-dessus de ladite première couche de matériau conducteur (54A) et desdites zones d'isolation (57), ladite deuxième phase de dépôt comprenant le dépôt d'une deuxième couche diélectrique (66),

- le procédé étant **caractérisé par** l'exécution, après ledit dépôt de ladite couche diélectrique (66), des phases suivantes :

   - une phase de définition de "séparateurs" (67) de ladite deuxième couche diélectrique (66) au-dessus de ladite première couche de matériau conducteur (54A) par une première gravure anisotrope de ladite deuxième couche diélectrique (66),
   - une phase d'abaissement de ladite première couche de matériau conducteur (54A) par une deuxième gravure anisotrope de ladite première couche de matériau conducteur (54A), de façon à fabriquer ladite grille flottante (54) avec une forme en U,
   - une phase de retrait desdits "séparateurs" (67), par une première gravure isotrope.

**2.** Le procédé selon la Revendication 1, **caractérisé en ce que** ladite deuxième couche diélectrique (66) possède une épaisseur allant de 5 nm à 15 nm, de préférence de 10 nm.

**3.** Le procédé selon la Revendication 1 ou 2, **caractérisé en ce que** ladite deuxième couche diélectrique (66) contient de l'oxyde de silicium ou du nitrure de silicium.

**4.** Le procédé selon la Revendication 1, **caractérisé en ce que** ladite première gravure anisotrope et ladite première gravure isotrope comprennent l'utilisation d'une composition de gravure sélective par rapport à ladite première couche de matériau conducteur (54A).

**5.** Le procédé selon la Revendication 1, **caractérisé en ce que** ladite deuxième gravure anisotrope comprend l'utilisation d'une composition de gravure sélective par rapport à ladite deuxième couche diélectrique (66).

**6.** Le procédé selon la Revendication 1, **caractérisé en ce que** ladite deuxième phase de dépôt comprend le dépôt d'une deuxième couche de matériau conducteur (54B).

**7.** Le procédé selon la Revendication 6, **caractérisé par le fait qu'**il comprend en outre une phase de gravure anisotrope de ladite deuxième couche de matériau conducteur (54B) et de ladite première couche de matériau conducteur (54A), de façon à fabriquer ladite grille flottante (54) avec une forme en U.

**8.** Le procédé selon la Revendication 6, **caractérisé en ce que** ladite deuxième couche de matériau conducteur (54B) comprend le même matériau conducteur que ladite première couche de matériau conducteur (54A).

**9.** Le procédé selon la Revendication 6 ou 8, **caractérisé en ce que** ladite deuxième couche de matériau conducteur (54B) contient du silicium fortement polycristallin dopé ou non dopé.

**10.** Le procédé selon la Revendication 6 ou 9, **caractérisé en ce que** ladite deuxième couche de matériau conducteur (54B) possède une épaisseur allant de 5 nm à 15 nm.

**11.** Le procédé selon la Revendication 7, **caractérisé en ce que** ladite gravure anisotrope comprend l'utilisation d'une composition de gravure sélective par rapport audit oxyde de champ (65).

**12.** Le procédé selon la Revendication 1 ou 7, **caractérisé par le fait qu'**il comprend, après ladite phase de formation de ladite grille flottante (54), les phases suivantes :

   - une phase d'abaissement de la surface exposée desdites zones d'isolation (57) de manière à découvrir lesdites parois latérales (54L) de ladite grille flottante (54),
   - une phase de formation d'une grille de commande (56) électriquement isolée de ladite grille flottante (54) par une troisième couche diélectrique (55).

**13.** Le procédé selon la Revendication 12, **caractérisé en ce que** ladite phase d'abaissement comprend une gravure humide, en particulier en présence d'acide fluorhydrique (HF).

**14.** Le procédé selon l'une quelconque des Revendications 1 à 5 ou 12, **caractérisé en ce que** ladite première couche de matériau conducteur (54A) possède une épaisseur allant de 30 nm à 150 nm.

**15.** Le procédé selon l'une quelconque des Revendications 6 à 12, **caractérisé en ce que** ladite première couche de matériau conducteur (54A) possède une épaisseur allant de 30 nm à 40 nm.

16. Le procédé selon l'une quelconque des Revendications précédentes, **caractérisé en ce que** ladite première couche de matériau conducteur (54A) contient du silicium polycristallin dopé ou non dopé.

17. Le procédé selon l'une quelconque des Revendications précédentes, **caractérisé en ce que** lesdites zones d'isolation (57) sont de type STI (isolation à tranchée peu profonde).

## Fig.1

(PRIOR ART)

100

4 {

8

7

6

5

1

2

3

10

AA'

8

7

6

5

3

9

BB'

# Fig.2

## (PRIOR ART)

EP 1 675 180 B1

Fig.3

(PRIOR ART)

300

8

7

6A

5

3

9

BB'

EP 1 675 180 B1

Fig.4

(PRIOR ART)

100

W1

L

T1

6

300

W2

L

T2

6A

BB'

EP 1 675 180 B1

Fig.5

Fig.6A

63

54A

53

50

Fig.6B

63

54A

53

50

57

EP 1 675 180 B1

Fig.6C

53

63

65

54A

65

57

50

Fig.6D

53

65

54A

65

57

50

## Fig.7A

## Fig.7B

EP 1 675 180 B1

Fig.7C

Fig.7D

EP 1 675 180 B1

Fig.7E

EP 1 675 180 B1

## Fig.8A

## Fig.8B

EP 1 675 180 B1

Fig.8C

Fig.8D

**EP 1 675 180 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6153472 A
- US 20030077907 A